Europäisches Patentamt

European Patent Office

Office européen des brevets

(11) Numéro de publication: **0 196 726**
**B1**

(12) **FASCICULE DE BREVET EUROPEEN**

(45) Date de publication du fascicule du brevet: **04.07.90**

(21) Numéro de dépôt: **86200537.8**

(22) Date de dépôt: **01.04.86**

(51) Int. Cl.⁵: **H 05 K 7/10, H 01 R 23/72, H 01 R 9/09**

(54) **Système électronique constitué de modules empilables.**

(30) Priorité: **05.04.85 FR 8505263**

(43) Date de publication de la demande:
**08.10.86 Bulletin 86/41**

(45) Mention de la délivrance du brevet:
**04.07.90 Bulletin 90/27**

(84) Etats contractants désignés:
**DE FR GB NL**

(56) Documents cités:
**DE-A-2 037 385**
**FR-A-2 096 541**
**GB-A-2 095 039**
**GB-A-2 130 025**
**US-A-3 551 750**
**US-A-3 904 934**
**US-A-4 045 105**
**US-A-4 395 084**

(73) Titulaire: **PHILIPS COMPOSANTS**
**117, quai du Président Roosevelt**
**F-92130 Issy les Moulineaux (FR)**
(84) **FR**

(73) Titulaire: **N.V. Philips' Gloeilampenfabrieken**
**Groenewoudseweg 1**
**NL-5621 BA Eindhoven (NL)**
(84) **DE GB NL**

(72) Inventeur: **Sorel, Alain**
**209 rue de l'Université**
**F-75007 Paris (FR)**

(74) Mandataire: **Caron, Jean et al**
**SOCIETE CIVILE S.P.I.D. 209, rue de l'Université**
**F-75007 Paris (FR)**

Courier Press, Leamington Spa, England.

**Description**

La présente invention concerne un système constitué d'un empilage de modules électroniques attachés les une aux autres et interconnectés électriquement pour transmettre des signaux entre aux ainsi que vers l'extérieur, chacun de ces modules comprenant un circuit électrique, pouvant réaliser une fonction différente, constitué électrique, pouvant réaliser une fonction différente, constitué de composants câblés sur un support plat imprimé rectangulaire muni de plages de contact le long d'au moins un de ses côtés et placé dans un boîtier isolant plat, des liaisons électriques étant assurées entre les plages d'un circuit placé dans un desdits boîtiers et celles d'un autre circuit placé dans un desdits boîtiers, chaque boîtiers étant muni de moyens pour maintenir à la fois le circuit et une pluralité de conducteurs electriques indépendente du circuit, chacune des conducteurs électriques correspondant à une desdites plages de contact de support étant pressé contre elle et dépassant au travers d'une face du boîtier dont l'autre face est d'ailleurs munie d'ouvertures, lesdits boîtiers étant tous mécaniquement identiques et pourvus de moyens d'accrochage entre aux.

De tels modules sont utilisés en électronique lorsque les systèmes doivent être adaptés facilement de façon à satisfaire des besoins spéciaux de l'utilisateur, doivent pouvoir être augmentés en fonction des besoins variables de l'utilisateur et doivent pouvoir être modifiés facilement. Ces modules peuvent donc être rapidement ajoutés à un système ou retirés d'un système, pour modifier ce dernier.

Un tel système est décrit dans un article du 1er janvier 1985 de la revue "Electronics week" pages 97, 98, intitulé "Domino-like modules build computers", et représenté par la photographie qui accompagne cet article. Un système du même genre est décrit plus en détails par le brevet US—A—4045105.

Ces systèmes sont basés sur l'emploi de broches et de douilles complexes et relativement coûteuses. En outre, ces broches introduisent des contacts intermédiaires entre deux circuits voisins, ce qui augmente la résistance des connexions et diminue la fiabilité.

L'invention se propose de fournir un mode de réalisation d'un tel système dans lequel on utilise des circuits tels que des circuits imprimés ou des substrats dits hybrides à couches épaisses ou à couches minces, sur lesquels la totalité des composants utilisés peuvent être montés en une seule passe selon une technologie standard.

L'invention fournit des boîtiers spécialement adaptés à la tenue mécanique des circuits et à leur interconnexion et qui autorisent le maximum d'interchangeabilité, de densité, de modularité, et permettant une grande souplesse en ce qui concerne les entrées/sorties spécifiques de chaque circuit et la puissance qu'ils peuvent dissiper. Elle permet en outre d'obtenir des connexions entre substrats voisins qui, tout en restant immédiatement démontables, ont une excellente résistance électrique et une excellente fiabilité.

Le système selon l'invention est notamment remarquable en ce qu'à chaque plage de contact sur une face du support correspond une plage de contact située en vis à vis sur l'autre face et qui lui est électriquement reliée, en ce que les ouvertures situées sur l'autre face du boîtier laissent apparaître les susdites plages en vis à vis du support, et en ce que les extrémités élastiques desdits conducteurs viennent directement en contact avec les plages correspondantes elles-mêmes en vis à vis d'un support contenu dans un boîtier adjacent lorsque les boîtiers sont attachés.

Ladite pluralité de conducteurs électriques est avantageusement constituée par des fils élastiques en matériau électriquement conducteur isolés les uns des autres et tenus ensemble alignés par une barrette isolante, le boîtier comportant un logement pour maintenir en position ladite barrette isolante avec ses conducteurs. Ces fils élastiques sont avantageusement faits en fil à ressort et comportent des boudins enroulés chacun sur au moins un tour. En outre les barrettes isolantes présentent, entre les deux boudins de chaque conducteurs, une partie en forme de queue d'aronde pour maintenir le conducteur.

Selon un mode de réalisation particulier où au moins un circuit est muni d'une plaque-radiateur, cette plaque dépasse à l'extérieur du circuit d'un côté qui ne comporte pas de plages de contact, et les boîtiers sont munis d'un orifice en correspondance avec cette plaque pour la laisser dépasser à l'extérieur.

Selon un autre mode de réalisation particulier où au moins un circuit émet ou reçoit certains signaux exclusivement vers l'extérieur, ou de l'extérieur, le support comporte des connexions le long d'un côté qui ne sert ni au refroidissement ni au contact vers les autres modules via les susdits conducteurs, en les boîtiers comportent une ouverture en correspondance avec ce côté pour permettre l'introduction d'un connecteur.

L'invention concerne aussi un système de microinformatique muni d'un micro-processeur selon la revendication 8 remarquable en ce que son unité centrale, ses modules de mémoire, ses interfaces de liaison entrée/sortie sont constitués chacun par un module selon l'invention.

La description qui va suivre en regard des dessins annexés décrivant des examples non limitatifs fera bien comprendrecomment l'invention peut être réalisée.

la figure 1 représente vu en perspective, un système électronique selon l'invention.

La figure 2 représente une vue éclatée d'un module élémentaire du système.

La figure 3 représente une vue en coupe d'un empilage de deux modules et la figure 4 représente une autre vue en coupedu même empilage de modules.

La figure 5 représente à plus grande échelle une partie de la barrette 10 et un conducteur 7 de la figure 2.

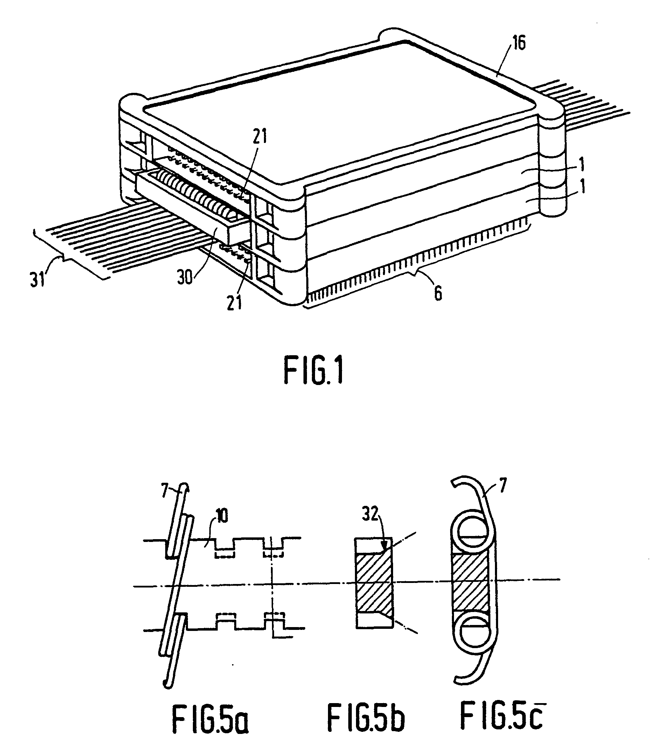

Le système de la figure 1 est obtenu par superposition de trois modules 1 mécaniquement identiques de manière à former une pile pouvant comporter toutes sortes de modules fonctionnellement différents. Le module inférieur est ici différent des deux autres et comporte des broches 6 pour le relier à un circuit imprimé de base. Comme on le verra plus loin, cette disposition n'est pas obligatoire. Des orifices latéraux au travers desquels sont accessibles des broches 21 permettant le branchement d'un connecteur 30 auquel une nappe deconducteurs plate 31 est cablée. Un couvercle 16 recouvre et protége l'ensemble. Il peut être immédiatement enlevé pour ajouter un autre module, et replacé sur ce dernier.

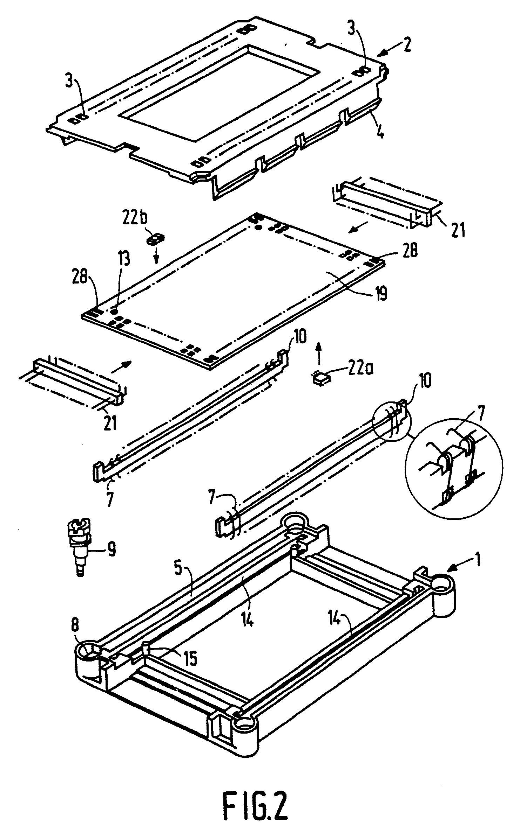

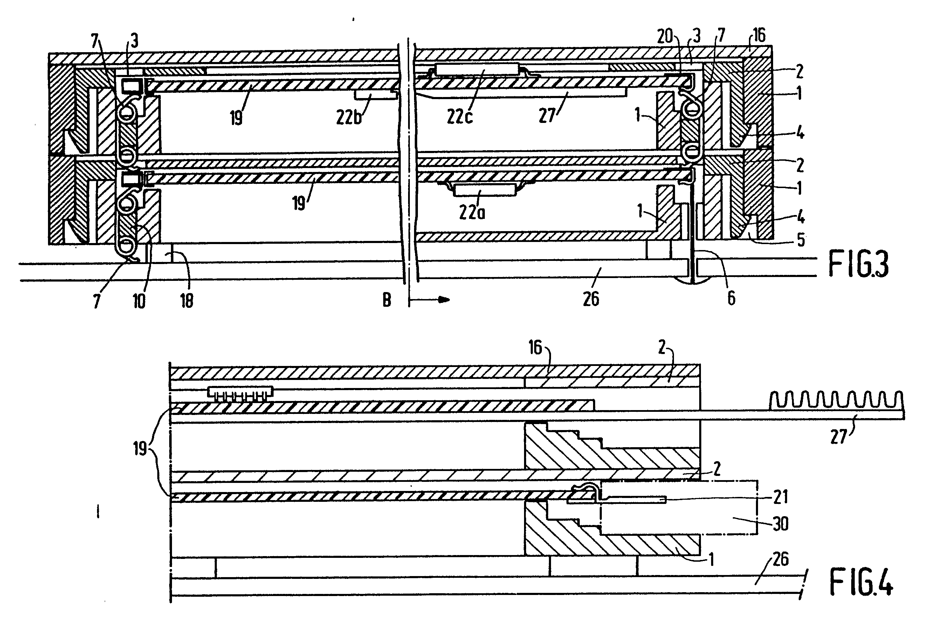

Les constituants d'un module selon l'invention sont représentés en détail sur la figure 2. La manière dont ils s'assemblent apparaitra plus loin lors de la description de la figure 3.

Les différents modules sont interconnectés électriquement entre eux pour transmettre des signaux. La transmission des signaux entre modules adjacents se fait par l'intermédiaire de fils métalliques 7 qui dépassent à l'extérieur du module au travers d'une fente 14. Pour accrocher les modules les uns aux autres, des colonnes creuses 8 sont prévues ainsi que des vis 9. Le module de la figure 2 est constitué par une boîte plate 1 en matériau isolant qui comporte l'orifice 14 en forme de fente et un couvercle 2 également en matériau isolant.

Le couvercle est lui-même assemblé à la boîte au moyende crochets 4 qui entrent dans les gorges 5. L'ensemble d'un empilage de tels modules est conçu pour être lui-même fixé à une plaque de circuit imprimé dite "carte mère" avec laquelle des contacts peuvent être obtenus au moyen des mêmes fils métalliques 7 qui entrent en contact avec les plages de la cartemère de circuit imprimé.

A partir du haut de la figure 2 sont représentés successivement un couvercle 2, un circuit électronique constitué de composants 22 câblés sur un support plat imprimé 19, puis une barette 10 munis de fils métallique de contact 7 constituant une pluralité de conducteurs électriques indépendants du circuit. Pour simplifier le dessin, quatre fils ont été représentés mais il est bien évident que la barrette en est pourvue sur toute sa longueur. Une boîte 1 est enfin représentée. Elle est ici en forme du cadre, et le couvercle 2 est ouvert par une large échancrure, pour permettre un accès vers le circuit 19. Ils pourraient bien entendu aussi être fermés complètement.

Le support 19 rectangulaire est muni de plages de contact 28 le long de ses deux grande côtés et à chaque plage de contact sur une face du support correspond une plage située en vis à vis sur l'autre face. Si ce support 19 est un circuit imprimé, les plages en vis à vis peuvent être réunies par un trou métallisé qui peut être situé par exemple en bordure de ces plages. Ces plages en vis à vis peuvent aussi être électriquement reliées par des cavaliers (non représentés) placés à cheval sur la tranche du substrat, du type employé pour les connexions des circuits céramiques à couches épaisses, connexions fournies en bande par un certain nombre de fabricants. Cette techniques d'interconnexion entre faces est employée avantageusement lorsque le support 19 est un substrat de céramique par exemple à couches épaisses.

Le couvercle 2 est muni d'ouvertures 3 au travers desquelles les plages 28 du support 19 peuvent être accessibles à partir du l'extérieur du module c'est-à-dire, sur la figure 2, à partir du dessus du couvercle 2. Le couvercle est muni de deux fois quatre crochets 4 qui pénétrent dans les gorges 5 de la boîte 1 afin de fixer ensemble le couvercle et la boîte. La boîte est elle même munie des colonnes creuses 8 destinées à accrocher entre eux le module représenté et un module voisin pour former un empilage. Das vis 9 pénètrent au travers des colonnes 8 du module et dans leur tête creuse peut être vissée la vis du module ajacent.

La boîte 1 est munie de fentes 14 dans lesquelles la barrette 10 est positionnée. Cette barrette 10 supporte une pluralité de conducteurs électriques 7 constitués par des fils élastiques en matériau électriquement conducteur isolés les uns des autres et tenus ensemble alignés par la barrette. Lorsque la barrette 10 est montée dans la fente 14 et que le support 19 est monté dans la boîte 1, et fixé au moyen des têtons 15 entrant dans des trous 13 et par exemple écrasés à chaud, les conducteurs constitués de fils élastiques 7 sont chacun en correspondance avec une plage du support 19 et en contact électrique avec elle. Ce contact est assuré par un dimensionnement de l'ensemble qui amène les fils 7 à être pressés contre les plages, situées ici sous le substrat 19, en correspondance avec les plages 28 (cette disposition est montrée sur la figure 3 qui est une coupe selon un plan perpendiculaire aux barrettes 10). L'autre extrémité des fils 7 (par rapport à celle qui est pressée contre les plages) dépasse à l'extérieur de la boîte 1, et peut pénétrer au travers des ouvertures 3 du couvercle d'un boîtier adjacent pour venir en contact avec les plages d'un support 19 contenu dans ce boîtier adjacent. Ainsi les contacts sont assurés au moyen des conducteurs 7 entre les plages d'un circuit placé dans un boîtier et celles d'un autre circuit placé dans un autre boîtier, un conducteur correspondant chaque fois à une plage du support, et les plages étant en vis à vis d'un boîtier à l'autre lorsque les boîtiers sont attachés ensemble.

Un côté du support 19 qui ne porte pas les plages 28 destinées à l'interconnexion des modules entre eux peut être utilisé pour y placer des broches de connexion 21 qui dépassent à l'extérieur de la boîte et peuvent être mises en connexion avec un connecteur enfiché dans une ouverture appropriée sur le côté de la boîte. Ce connecteur assure une communication seulement avec l'étage de module correspondant dans l'empilage. Par exemple dans un système informatique le bus serait véhiculé par l'ensemble de connexions verticales d'un module à l'autre, assurées par les fils métalliques, et les entrées/sorties spécifiques à chaque étage seraient effectuées via les broches 21.

Des deux cotés de la figure 3, sont représentés les crochets 4 mentionnés plus haut qui permettent l'accrochage du convercle 2 et de la boîte 1. Les barriettes 10 sont représentées en coupe et la figure met en évidence la manière selon laquelle les fils 7 entrent en contact avec les cavaliers 20 mentionés plus haut, à cheval sur les bords des circuits céramique 19 (sur la partie droite de la figure) ou bien avec des plages reliées entre elles par un trou métallisé d'un circuit imprimé (sur la partie gauche de la figure). Un circuit imprimé sera choisi avec une épaisseur légèrement plus grande que celle du support céramique équivalent, pour compenser l'absence des cavaliers 20 dont l'épaisseur n'est pas négligeable et arriver à la même épaisseur totale entre les contacts en vis à vis. La figure montre également comment les fils 7 pénètrent au travers du couvercle du module inférieur et sont pressés contre les cavaliers ou les plages du circuit électronique de ce derner, comment elles viennent également (à gauche sur la figure) en pression contre la carte mère 26, et comment les plages du circuit du module supérieur sont accessibles au travers d'orifices 3. Un couvercle 16 a été représenté dont le rôle secondaire est de fermer l'extrémité supérieure du module supérieur de l'ampilage pour en protéger le circuit électronique. Le boîtier représenté en bas et à droite, et son couvercle, sont d'un modèle fermé. En bas et à droite on a représenté un mode particulier de connexion du circuit 19 à une plaque de base 26, au moyen de broches 6 d'un type connu, fixées au substrat et qui dépassent à l'extérieur dela boite 1. La connexion peut aussi être réalisée, comme représenté à gauche, par les fils 7, appuyés sur la plaque de base 26.

Fixés aux supports de circuit électrique sont représentés des composants 22a, b, c pour suggérer diverses possibilités de montage sur lesdits supports. En outre une plaque métallique 27 conductrice de la chaleur peut être fixée sous un tel support pour en évacuer les calories.

La figure 4 représente une coupe selon la ligne B de la figure 3. Elle permet de bien comprendre comment le radiateur 27 dépasse à une extrémité du support 19, qui ne comporte pas de plage de contact, jusqu'à l'extérieur du boîtier en passant par un orifice du boîtier. Cet orifice est le même que celui par lequel on peut introduire le susdit connecteur enfiché sur le côté de la boîte. Le radiateur peut être muni d'ailettes de refroidissement à l'extérieur du boîtier. De même sont représentees à l'étage inférieur de l'empilement des broches de sortie 21, et un connecteur 30 est suggéré en pointillés. La figure 5 représente un élément de barrette 10 avec un conducteur 7 fait en fil à ressort. Chaque fil 7 comporte deux boudins enroulés ici sur deux tours. Ces fils boudinés autorisent une grande amplitude de déplacement élastique de l'extrémité du fil et permettent d'assurer un excellent contact, même avec de larges tolérances mécaniques. La figure 5b montre en coupe la barrette 10 avant le montage d'un conducteur, elle présente une partie 32 en forme de queue d'aronde qui pénètre entre le boudin et la partie verticale du fil (figure 5c) et maintient efficacement ce dernier.

Les modules selon l'invention sont utilisés avantageusement pour constituer un ensemble de micro-informatique muni d'un microprocesseur, son unité centrale étant montée dans un des modules, une mémoire dans un autre module, une interface d'entrée/sortie par exemple vers un terminal conversationnel ou vers un capteur ou un actionneur de machine étant située dans unmodule spécifique, et d'une manière générale chaque sous-ensemble fonctionnel étant constitué par un module distinct. Ainsi toute configuration peut être constituée à la demande et reconfigurée très facilement en assemblant des modules selon l'invention.

**Revendications**

1. Système constitué d'un empilage de modules électroniques attachés les uns aux autres et interconnectés électriquement pour transmettre des signaux entre aux ainsi que vers l'extérieur, chacun de ces modules comprenant un circuit électrique, pouvant réaliser une fonction différente, constitué de composants câblés sur un support plat imprimé rectangulaire (19) muni de plages de contact le long d'au moins un de ses côtés et placé dans un boîtier isolant plat (1) des liaisons électriques étant assurées entre les plages d'un circuit placé dans un desdits boîtiers et celles d'un autre circuit placé dans un autre desdits boîtiers chaque boîtier étant muni de moyens pour maintenir à la fois le circuit et une pluralité de conducteurs électriques (7) indépendants du circuit chacun des conducteurs électriques correspondant à une desdites plages de contact du support étant pressé contre elle et dépassant au travers d'une face du boîtier dont l'autre face est d'ailleurs munie d'ouvertures (3), lesdits boîtiers étant tous mécaniquement identiques et pourvus de moyens d'accrochage (9) entre eux, caractérisé en ce qu'à chaque plage de contact sur une face du support correspond une plage de contact (28) située en vis à vis sur l'autre face et qui lui est électriquement reliée, en ce que les ouvertures (3) situées sur l'autre face du boîtier laissent apparaître les susdites plages (28) en vis à vis du support, et en ce que les extrémités élastiques desdits conducteurs (7) viennent directement en contact avec les plages correspondantes (28) elles-mêmes de vis à vis un support contenu dans un boîtier adjacent, lorsque les boîtiers sont attachés.

2. Système selon la revendication 1, caractérisé en ce que ladite pluralité de conducteurs électriques est constituée par des fils élastiques en matériau électriquement conducteur isolées les unes des autres et tenues ensemble alignées par une barrette isolante (10), et en ce que le boîtier comporte un logement (14) pour maintenir en position ladite barrette isolante avec ses conducteurs.

3. Système selon la revendication 2, caractérisé en ce que les conducteurs électriques sont faite en fil à ressort et comportent des boudins enroulés chacun sur au moins un tour.

4. Système selon la revendication 3 caractérisé en ce que les barrettes isolantes (10) présentent, entre les deux boudins de chaque conducteur, une partie en forme de queue d'aronde (32) pour maintenir le conducteur.

5. Système selon la revendication 2, caractérisé en ce que chaque boîtier est construit en deux parties dont l'une (1) comporte un logement (14) en forme de fente débouchant à l'extérieur pour la barrette et ses conducteurs élastiques, et supporte le circuit électrique, et l'autre (2) comporte les orifices (3) au travers desquels on peut accéder aux plages (28) dudit circuit.

6. Système selon l'une quelconque des revendications précédentes dans lequel au moins un circuit est muni d'une plaque (27) conductrice de la chaleur, caractérisé en ce que cette plaque dépasse à l'extérieur du circuit d'un côté qui ne comporte pas de plages de contact, et en ce que les boîtiers sont munis d'un orifice en correspondance avec cette plaque pour la laisser dépasser à l'extérieur.

7. Système selon l'une quelconque des revendications 1 à 5, dans lequel au moins un circuit émet ou reçoit certains signaux exclusivement vers l'extérieur, ou de l'extérieur, caractérisé en ce que le support comporte des connexions le long d'un côté qui ne sert ni au refroidissement ni au contact vers les autres modules via les susdits conducteurs, et en ce que les boîtiers comportent une ouverture en correspondance avec ce côté pour permettre l'introduction d'un connecteur (30).

8. Système de microinformatique muni d'un microprocesseur, caractérisé en ce que son unité centrale, ses modules de mémoire, ses interfaces de liaison entrée/sortie, et ses sous-ensembles fonctionnels, constituent un système selon l'une des revendications précédentes.

**Patentansprüche**

1. System, das aus einer Stapelung aneinander befestigter und elektrisch miteinander verbundener elektronischer Module besteht zum übertragen von Signalen untereinander sowie nach draußen, wobei jedes der Module eine elektrische Schaltung aufweist, die je eine andere Funktion haben können und die aus verdrahteten Elementen auf einer rechteckigen Printplatte (19) bestehen, die an wenigstens einer der Seiten mit Kontaktflächen versehen und in einem flachen Isoliergehäuse untergebracht ist, sowie mit elektrischen Verbindungen zwischen den Flächen einer Schaltungsanordnung in einem der genannten Gehäuse und denen einer anderen Schaltungsanordnung in einem der anderen genannten Gehäuse, wobei jedes Gehäuse mit Mitteln versehen ist um die Schaltungsanordnung sowie eine Anzahl elektrischer Leiter, unabhängig von der Schaltungsanordnung am Platz zu halten, wobei jeder der elektrischen Leiter (7) mit einer der genannten Kontaktflächen des Trägers zusammenarbeitet, gegen dieselbe gedrückt ist und durch eine Fläche des Gehäuses hindurchgeht, dessen andere Fläche mit Öffnungen (3) versehen ist, wobei die genannten Gehäuse in mechanischer Hinsicht alle gleich und mit Mitteln (9) zum gegenseitigen Festhaken versehen sind, dadurch gekennzeichnet, daß jede Kontaktfläche auf einer Seite des Trägers einer auf der anderen Seite gegenüber liegenden Kontaktfläche (28) entspricht und mit derselben elektrisch verbunden ist, daß die Öffnungen (3) auf der anderen Seite des Gehäuses die oben genannten Flächen (28) gegenüber dem Träger frei lassen, und daß die federnden Enden der genannten Leiter (7) direkten Kontakt mit den genannten entsprechenden Flächen (28) machen, die selbst gegenüber einem durchgehenden Träger in einem benachbarten Gehäuse liegen, wenn die Gehäuse aneinander befestigt sind.

2. System nach Anspruch 1, dadurch gekennzeichnet, daß die genannte Anzahl elektrischer Leiter aus federnden Drähten aus elektrisch leitendem Werkstoff bestehen, gegenüber einander isoliert sind und durch einen Isolierstab (10) in einer Reihe zusammengehalte werden, und daß das Gehäuse eine Ausnehmung (14) aufweist um den genannten Isolierstab mit den Leitern am Platz zu halten.

3. System nach Anspruch 2, dadurch gekennzeichnet, daß die elektrischen Leiter aus einem federnden Draht hergestellt sind und Schraubenfedern aufweisen, die über wenigstens eine Windung gewickelt sind.

4. System nach Anspruch 3, dadurch gekennzeichnet, daß die Isolierstäbe zwischen den beiden Schraubenfedern jedes Leiters einen Teil in Form eines Schwalbenschwanzes (32) aufweist um den Leiter am Platz zu halten.

5. System nach Anspruch 2, dadurch gekennzeichnet, daß jedes Gehäuse aus zwei Teilen zusammengestellt ist, von denen der eine Teil (1) eine Ausnehmung (14) in Form eines auf der Außenseite mündenden Schlitzes aufweist, und zwar für den Stab und die federnden Leiter und der andere Teil (2) die Öffnungen (3) aufweist, durch die hindurch die Gebiete (28) der genannten Schaltungsanordnung erreichbar sind.

6. System nach einem der vorstehenden Ansprüche, in dem wenigstens eine Schaltungsanordnung mit einer wärmeleitenden Platte (27) versehen ist, dadurch gekennzeichnet, daß diese Platte über den Außenumfang der Schaltungsanordnung hinausragt auf einer Seite, die keine Kontaktzonen aufweist, und daß die Gehäuse mit einer der genannten Platte entsprechende Öffnung aufweist, durch die diese Platte hinausragen kann.

7. System nach einem der Ansprüche 1 bis 5, bei dem mindestens eine Schaltungsanordnung bestimmte Signale nach draußen sendet bzw. von draußen empfängt, dadurch gekennzeichnet, daß der Träger an einer Seite, die weder zum Kühlen noch zum Kontaktieren dient, Verbindungen aufweist, und daß die Gehäuse eine dieser Seite entsprechende Öffnung aufweisen, durch die hindurch ein Stecker (30) eingeführt werden kann.

8. Mikrodatensystem mit einem Mikroprozessor, dadurch gekennzeichnet, daß die zentrale Einheit, die Speichermodule, die Eingangs-Ausgangs-Schnittstellen, die funktionellen Untergruppen ein System nach einem der vorstehenden Ansprüche bilden.

**Claims**

1. A system constituted by a stack of electronic modules attached to each other and electrically interconnected for transmitting signals between them and to the exterior, each module comprising an electric circuit which can carry out a different function constituted by components wired on a flat rectangular support (19) provided with contact regions along at least one of its sides and arranged in a flat insulating housing (1), electrical connections being provided between the contact areas of a circuit arranged in one of the said housings and those of another circuit arranged in another of the said housings, while each housing is provided with means for holding in place both the circuit and a plurality of electric conductors (7) independent of the circuit, each electric conductor corresponding to one of the said contact regions of the support and being pressed against it while running across one surface of the housing, whose other surface is provided with openings (3), the said housings alll being mechanically identical to each other and being provided with means (9) for hooking them to each other, characterized in that to each contact region on one surface of the support corresponds a contact region (28) situated opposite thereto on the other surface and connected electrically thereto, in that the openings (3) situated on the other surface permit the appearance of the said regions (28) on opposing sides of the support, and in that the elastic ends of the said conductors (7) directly establish contact with the corresponding opposing regions (28) of a support arranged in an adjacent housing when the housings are attached.

2. A system as claimed in Claim 1, characterized in that the said plurality of electrical conductors is constituted by elastic wires of an electrically conducting material insulated from each other and held together in an aligned position by an insulating rod (10), and in that the housing has a recess (14), for holding in place the said insulating rod with its conductors.

3. A system as claimed in Claim 2, characterized in that the electrical conductors are made of spring wire and comprise helical springs each wound through at least one turn.

4. A system as claimed in Claim 3, characterized in that the insulating rods (10) have between the two helical springs of each conductor a part in the form of a dovetail (32) for holding the conductor in place.

5. A system as claimed in Claim 2, characterized in that each housing is composed of two parts, one (1) of which has a recess (14) in the form of a slot merging at the exterior for the rod and its elastic conductors and supports the electric circuit, while the other part (2) has openings (3) through which the regions (28) of the said circuit are accessible.

6. A system as claimed in any one of the preceding Claims, in which at least one circuit is provided with a thermally conducting plate (27), characterized in that this plate projects beyond the exterior of the circuit on a side which does not comprise contact regions, and in that the housings are provided with an opening corresponding to the said plate, through which it can project beyond the exterior.

7. A system as claimed in any one of Claims 1 to 5, in which at least one circuit transmits or receives certain signals exclusively to the exterior or from the exterior, characterized in that the support comprises connections along a side which serve neither for cooling nor for contacting the other modules *via* the aforementioned conductors, and in that the housings have a corresponding opening to this side through which a conductor (30) can be introduced.

8. A microdata system provided with a microprocessor, characterized in that its central unit, its memory modules, its input/output connection interfaces and more generally its functional subassemblies are each constituted by a module as claimed in any one of the preceding Claims.

FIG.1

FIG.5a     FIG.5b     FIG.5c

1

FIG.2

FIG.3

FIG.4

EP 0 196 726 B1